Europäisches Patentamt

European Patent Office

Office européen des brevets

(11) Publication number: **0 005 946**
**B1**

# EUROPEAN PATENT SPECIFICATION

(45) Date of publication of patent specification: **17.10.84**

(21) Application number: **79300877.2**

(22) Date of filing: **18.05.79**

(51) Int. Cl.³: **G 01 R 23/00, G 01 P 3/48,
G 05 B 1/02, H 03 K 5/26**

(54) **Time-period comparing device.**

(30) Priority: **23.05.78 JP 61279/78**

(43) Date of publication of application:
**12.12.79 Bulletin 79/25**

(45) Publication of the grant of the patent:
**17.10.84 Bulletin 84/42**

(84) Designated Contracting States:
**DE FR GB NL**

(56) References cited:
**US-A-3 521 174
US-A-3 619 651
US-A-3 739 367
US-A-3 757 233
US-A-3 877 003
US-A-3 956 705
US-A-3 989 960**

**WIRELESS WORLD, September 1974, vol. 80,
nr. 1465 Haywards Heath A. BISHOF and A.
WOODSUFF: "A digital speedometer using
c.m.o.s.", pages 316-320**

(73) Proprietor: **FUJITSU LIMITED
1015, Kamikodanaka Nakahara-ku
Kawasaki-shi Kanagawa 211 (JP)**

(72) Inventor: **Asami, Fumitaka
27, Fujimidai 1-chome
Kunitachi-shi Tokyo 186 (JP)**

(74) Representative: **Abbott, Leonard Charles et al
GILL JENNINGS & EVERY 53-64 Chancery Lane
London WC2A 1HN (GB)**

## Description

The present invention relates generally to a time-period comparing device for comparing the time-period of a signal with that of a predetermined reference signal and, more particularly, to a time-period comparing device adapted to computer systems and electric switching systems, in which, for example, the device may be used for the monitoring of cooling fans for cooling the electrical or electric components of the systems.

In a computer system or an electric switching system, a considerable number of electrical or electric components, such as integrated circuits (hereinafter referred to as ICs) are contained in a cabinet which is of a relatively small size. During the operation of the components, they generate heat so that they themselves are heated up. However, the components, including transistors, diodes, etc., are designed to function only under the right conditions. For example, the components operate properly only within a predetermined range of temperature. Furthermore, the components may be damaged if exposed to too high a temperature. At present, in order to prevent the components from being overheated, the components are cooled by using cooling fans. Therefore, it is necessary to monitor the rotational velocity of the fans continuously and to provide an alarm signal when the rotational velocity drops to less than a predetermined value.

In a monitoring device for monitoring the rotational velocity of a fan of the prior art, a motor for driving the fan is provided with a tachometer generator, so that the device produces an alarm signal when the output of the tachometer generator drops to less than a predetermined value. However, it is difficult to mount the device on a cooling fan system since the device is of a relatively large size. Furthermore, the cost of the device is high.

Another monitoring device for monitoring the rotational velocity of a fan of the prior art includes a sensor for detecting the rotational velocity of a fan photoelectrically or electromagnetically. Also, the monitoring device includes an electric circuit for comparing the rotational velocity signal generated from the sensor with a reference signal which is generated by using a monostable multivibrator. However, since the period of the rotational velocity of the fan is relatively long, a capacitor for determining the reference period of the monostable multivibrator is of a high capacitance. Therefore, if this device is manufactured as an IC, the capacitor has to be connected outside the IC so that the number of terminals of the IC increases, which number is limited by mechanical tolerance associated with the physical dimensions of the IC. In addition, elements, such as capacitors and resistors, for determining the period of the reference signal are affected by various ambient conditions, for example, ambient temperature, so that the period of the reference signal is unstable.

It has previously been proposed, in US specification No. 3877003, to provide a warning system for belt slippage in an internal combustion engine, by generating a first train of pulses with a frequency proportional to the engine revolutions and a second train of pulses at a much higher frequency, proportional to the revolution of a rotary member, for example an alternator, driven from the engine by means of a belt. A counter receives pulses of the higher frequency pulse train through a gate controlled by the lower frequency pulse train waveform, which also periodically resets the counter. An alarm signal is generated or not generated at an output terminal depending on whether the count reaches or does not reach a predetermined number before resetting takes place.

In some cases, a signal representing the rotation of velocity of a fan, for example, may be subject to some irregularity, for example when it is derived from an inductance coil excited by a strong electromagnetic field generated in the proximity of a motor for driving the fan. The present invention has for its object to provide means preventing a period comparing device from responding to rapid changes of an irregular nature.

The present invention starts from a period comparing device for comparing the period of a first signal with a second period defined by a predetermined multiple of a shorter period of a second signal, the second period being obtained by means of a counter receiving the second signal and reaching a count equal to the predetermined multiple if not previously interrupted by the said first signal and generating either a rectangular signal defining the reference period or a definite level signal, the type of signal generated depending on the period of the first signal being longer or shorter than the reference period, and comprising a signal circuit producing two different definite-level signals depending on the period of the first signal being longer or shorter than the said reference period, and is characterized

a)  in that the first signal is an input signal to be monitored,

b)  an oscillator provides the signal of shorter period and

c)  by means for preventing the device for operating when the input signal is an irregular signal, the preventing means having two output states, the preventing means in the first output state counting the number of pulses derived from the input signal following a change in the signal circuit output, and being reset by a subsequent output signal provided by the signal circuit if that signal arrives before the number of pulses has reached a predetermined value, the preventing means in the second output state counting the number of pulses derived from an output signal of the counter, following a change in the signal circuit output, and being reset by another subsequent output signal provided by the signal circuit if that signal arrives before the number of pulses has reached the predetermined value, the preventing means changing from one output state to the other following the corresponding change in the output of the signal circuit, only when the number of pulses derived from the input signal or from the output signal of the counter reaches the predetermined value.

U.S. specification No. 3361985 describes a circuit for causing a signal internally generated by a voltage controlled oscillator to track the frequency of an external signal; in this circuit, there are two lines, to each of which a train of pulses can be applied, a pulse train on the first of the lines adjusting the frequency of the oscillator in one direction and a pulse train on the second of the lines adjusting the frequency of the oscillator in the opposite direction. To prevent hunting due to noise signals, the train of pulses is transmitted to the oscillator adjusting means only after a predetermined number of pulses on one of the lines has been counted without the arrival of a pulse on the other of the lines. In the present invention, the preventing means counts the pulses in one of the pulse trains, but it is the output signal of the signal circuit, indicating the relationships between the periods of the pulse trains, which is followed by the output of the preventing means if the count of pulses following the change in signal circuit output reaches a predetermined number.

In the preferred form of the device embodying the invention, delay means are provided for preventing the device for operating for a definite interval after the power is turned on; in this preferred form, the delay means includes a third counter counting pulses generated by the oscillator, a latch circuit having one input connected to the counter output and the other connected to an initial reset means for the third counter, and a gate controlled by the output of this latch means for inhibiting the normal output of the preventing means for the said interval.

In US specification No. 3989960 there is described a chattering prevention circuit including a counter which, upon receiving an input signal of a chattering kind, such as from a switch contact, begins to count a clock signal; when the count reaches a predetermined value, a signal is generated to control a gate for the input signal.

A device embodying the invention may be made of small size and at low cost and in a form easy to mount on a cooling fan system, for example. It may be manufactured in an IC form with no external high value capacitors and able to operate stably, regardless of ambient conditions.

The present invention will be better understood from the ensuing description of an example thereof with reference to the accompanying drawings, in which:

Figure 1 is a block circuit diagram illustrating a period comparing device which may be used in the circuit of the present invention;

Figures 2A, 2B, 2C, 2D, 2E, 2F and 2G are timing diagrams showing the signals "a", "b", "c", "d", "e", "f" and "g", respectively, appearing in Figure 1;

Figures 3A, 3B, 3C, 3D, 3E, 3F and 3G are also timing diagrams showing the signals, "a", "b", "c", "d", "e", "f" and "g" respectively, appearing in Figure 1;

Figure 4 is a block circuit diagram illustrating a first embodiment of the present invention, including the period comparing device of Figure 1;

Figures 5A, 5B, 5C, 5D, 5E and 5F are timing diagrams showing the signals "a", "i", "f", "g", "j" and "k", respectively, appearing in Figure 4;

Figure 6 is a block circuit diagram of a second embodiment of the period comparing device of the present invention;

Figure 7 is a circuit diagram illustrating the input circuit 1 of the devices of Figures 1, 4 and 6;

Figure 8 is a circuit diagram illustrating the reference oscillator 2 of the devices of Figures 1, 4 and 6;

Figure 9 is a circuit diagram illustrating the binary counter stages of the devices of Figures 1, 4 and 6;

Figure 10 is a circuit diagram illustrating the signal circuit 4 of the devices of Figures 1, 4 and 6;

Figure 11 is a circuit diagram illustrating the preventing circuit 5 of the devices of Figures 4 and 6;

Figure 12 is a circuit diagram illustrating the initial reset circuit 7 of the device of Figure 6.

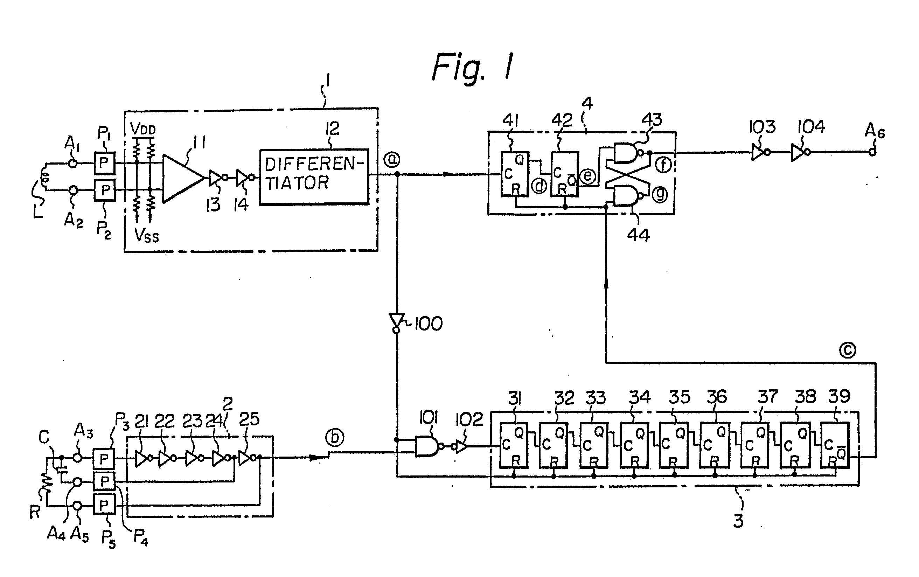

Referring to Figure 1, the time-period comparing device is mainly composed of an input circuit 1, a reference oscillator 2, a reference period counter 3 including, for example, nine binary counter stages 31, 32, ..., 39 connected in series, and a signal circuit 4 including two binary counter stages 41 and 42, and further, including a latch circuit formed by two NAND gates 43 and 44. The device is an eight-terminal module having two input terminals $A_1$ and $A_2$, three terminals $A_3$, $A_4$ and $A_5$ for connecting an external capacitor C and an external resistor R, which determine the frequency of the reference oscillator 2, an output terminal $A_6$ from which an alarm signal is transmitted to other devices, and direct current supply terminals $V_{SS}$ and $V_{DD}$. To the terminals $A_1$ through $A_5$ are connected protection circuits $P_1$ through $P_5$, respectively, for preventing a higher voltage signal than $V_{DD}$ from being input to the device.

In the input circuit 1 of Figure 1, a sine wave signal generated from a coil L is amplified by a differential amplifier 11. Next, after passing through inverters 13 and 14 the signal is differentiated by a differentiator 12 into a pulse-shaped wave signal "a". The signal "a" is supplied to a clock terminal of the binary counter stage 41 and through an inverter 100 to a reset terminal of each of the binary counter stages 31 through 39. The coil L is contained in a pickup (not shown) for detecting the rotational velocity of a fan (not shown) associated with a permanent magnet (not shown), which fan may be used for cooling a computer system or an electric switching system.

The reference oscillator 2 is composed of a series of five inverters 21, 22, 23, 24 and 25, in which the input of the inverter 21 is connected to the terminal $A_3$ via the protection circuit $P_3$ and the outputs of the inverters 24 and 25 are connected to the terminals $A_4$ and $A_5$ via the protection circuits $P_4$ and $P_5$, respectively. The oscillating frequency of the reference oscillator 2, which is, for example, 7.25 KHz, is determined by selecting the values of the capacitor C and the resistor R. Since the frequency is relatively high, the time constant for determining the frequency is smaller than that of the above-mentioned fan-monitoring prior art whose frequency is, for example, 28.3 Hz. In the present invention, the values of the capacitor C and the resistor R can be selected as 0.001 $\mu$F and 69 k$\Omega$, respectively, while in the above-mentioned prior art, the values of the capacitor C and the resistor R can be, for example, selected as 0.5 $\mu$F and 69 k$\Omega$, respectively.

The reference period counter 3 produces a reference period signal "c" by counting pulses generated by the reference oscillator 2 and received through a NAND gate 101 and inverted-input amplifier 102. For example, assuming that the frequency of the pulse-shaped signal "a" is relatively low, after each of the binary counter stages 31 through 39 is reset by the signal "a", so that the binary counter stage 39 produces a high logical level "H" which serves as an output of the reference period counter 3, the binary counter stages are sequentially set by the signal "b". Finally, when the binary counter stage 39 is set, the stage 39 inverts its output from a high logical level "H" to a low logical level "L". As a result, the reference period signal "c" becomes a rectangular wave signal whose frequency is the same as that of the signal "a". The width t of the rectangular wave of the signal "c" is, for example, 0.0353 sec ($=2^{9-1}/7250$), if the frequency of the reference oscillator 2 is 7.25 KHz. Next, assuming that the frequency of the pulse-shaped signal "a" is relatively high, for example, higher than 28.3 Hz corresponding to the time-period of 0.0353 sec, then before the binary counter stage 39 is set by the signal "b", each of the binary counter stages 31 through 39 is reset by the signal "a". Therefore, there is no chance for the binary counter stage 39 to be set, so that the reference period signal "c" remains at a high logical level "H". Thus, the reference period signal "c" is a rectangular wave signal when the frequency of the pulse-shaped wave signal "a" is lower than a predetermined value, for example, 28.3 Hz, while the reference period signal "c" remains at a definite level, namely, at a high logical level "H" when the frequency of the signal "a" is higher than the above-mentioned predetermined value. Such a reference period signal "c" is supplied to the signal circuit 4.

In the signal circuit 4 of Figure 1, the pulse-shaped signal "a" is supplied to a clock C of the binary counter stage 41, whose output Q is connected to a clock $\underline{C}$ of the binary counter stage 42. An output $\overline{Q}$ of the binary counter stage 42 is connected to an input of NAND gate 43 which is cross-coupled to NAND gate 44. The reference period signal "c" is supplied to resets R of the binary counter stages 41 and 42, and to an input of NAND gate 44. These NAND gates 43 and 44 form a latch circuit having two stable states. For example, in a first stable state of the latch circuit, an output of NAND gate 43 is at a low logical level "L", while an output of NAND gate 44 is at a high logical level "H". Similarly, in a second stable state of the latch circuit, the output of NAND gate 43 is at a high logical level "H", while the output of NAND gate 44 is at a low logical level "L". The first stable state turns into the second stable state only when the level of the signal "e" is at a low logical level "L" and the level of the signal "c" is at a high logical level "H". Contrary to this, the second stable state turns into the first stable state only when the level of the signal "e" is at a high logical level "H" and the level of the signal "c" is at a low logical level "L". The output of NAND gate 43 is connected to the output terminal A6 through inverters 103 and 104.

The operation of the device of Figure 1 will now be explained in greater detail.

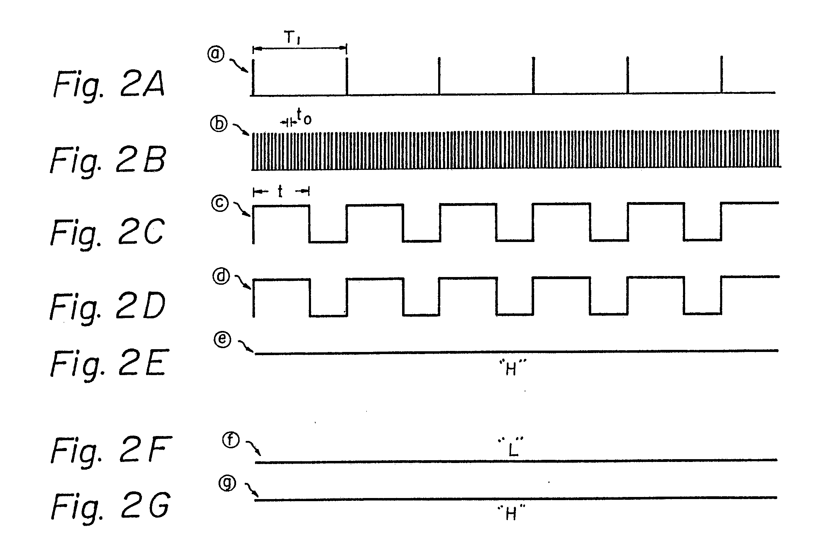

Figures 2A, 2B, 2C, 2D, 2E, 2F and 2G are timing diagrams showing the signals "a", "b", "c", "d", "e", "f" and "g", respectively, appearing in Figure 1. Assume that the rotational velocity of a fan (not shown) is lower than a predetermined value, for example, 1700 rpm, which corresponds to the frequency of 28.3 Hz and the time-period of 0.0353 sec. In this case, the signal "a", as shown in Figure 2A, at the output of the input circuit 1 is a pulse train signal whose time-period $T_1$ is greater than a predetermine value t, which equals 0.0353 sec, for example. On the other hand, the signal "b", as shown in 2B, at the output of the reference oscillator 2 is a pulse train signal whose time-period $t_0$ is, for example, 0.138 msec, which corresponds to the frequency of 7.25 KHz. After all of the binary counter stages 31 through 39 of the reference period counter 3 are reset by the signal "a", $2^{l-1}$ pulses of the signal "b", in which l equals 9 is this case, are supplied to the reference period counter 3, so that the last stage 39 is set. As a result, the last stage 39 inverts its output level from a high logical level "H" to a low logical level "L". Therefore, the last stage 39 produce a reference period signal "c", as shown in Figure 2C, in which the width t of the signal "c" is $t_0 \times 2^{l-1}$, namely, 0.0353 sec. This width t is a reference time-period of the device of Figure 1. The binary counter stage 41 of the signal circuit 4 is reset every time it receives a rear edge of the signal "c", as shown in Figure 2C, while the stage 41 is set every time it receives a pulse of the signal "a", as shown in Figure 2A. Therefore, the signal "d", as shown in Figure 2D, at the output of the binary counter stage 41 is similar to the signal "c", as shown in Figure 2C. Next, the binary counter stage 42 counts the rear edges of the signal "d". At the same time, the stage 42 is reset by the rear edges of the signal "c". As a result, the stage 42 remains at a reset state, so that the output $\bar{Q}$ of the stage 42 remains at a high logical "H", as shown in Figure 2E. Therefore, the output signal "f" of NAND gate 43 remains at a low logical level "L", as shown in Figure 2F, and the output signal "g" of NAND gate 44 remains at a high logical level "H", as shown in Figure 2G, since the signal "e" remains at a high logical level "H", even if the signal "c" repeats a high logical level "H" and a low logical level "L". As a result, a signal appearing at the output terminal $A_6$ becomes an alarm signal indicating that the rotational velocity of the fan has dropped to less than the predetermined value, for example, 1700 rpm.

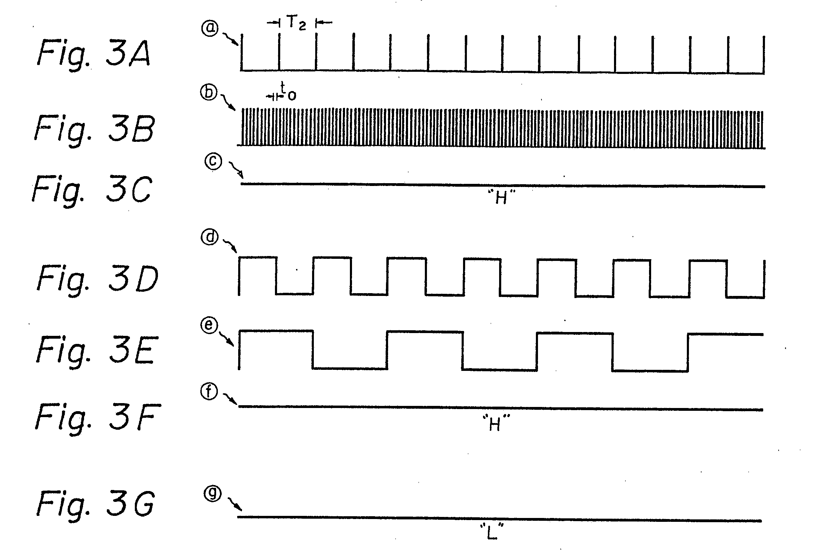

Figures 3A, 3B, 3C, 3D, 3E, 3F and 3G are also timing diagrams showing the signals "a", "b", "c", "d", "e", "f" and "g", respectively, appearing in Figure 1. Assuming that the rotational velocity of the fan is higher than the above-mentioned predetermined value, for example, 1700 rpm, the signal "a", as shown in Figure 3A, at the output of the input circuit 1 is a pulse train signal whose time-period $T_2$ is smaller than the predetermined value t, for example, 0.0353 sec. The signal "b" at the output of the reference oscillator 2 is shown in Figure 3B, which is the same as Figure 2B. After all of the binary counter stages 31 through 39 of the reference period counter 3 are reset by the signal "a", pulses of the signal "b" are counted so that the binary counter stages are sequentially set. However, the last stage 39 can not be set, since all of the stages 31 through 39 are reset again by the signal "a" before the last stage 39 is set. Therefore, the reference period signal "c" remains at a high logical level "H", as shown in Figure 3C, so that the binary counter stages 41 and 42 of the time-period comparator 4 do not remain in a reset state. As a result, each of the binary counter stages 41 and 42 operates as a 1/2 frequency divider. Therefore, the signal "d", as shown in Figure 3D, at the output Q of the binary counter stage 41 is a signal whose frequency is a half of that of the signal "a". Furthermore, the signal "e", as shown in Figure 3E, at the output $\bar{Q}$ of the

binary counter stage 42 is a signal whose frequency is a quarter of that of the signal "a". However, since the input of NAND gate 44 remains at a high logical level "H", the output siganl "f", as shown in Figure 3F, at the output of NAND 43 remains at a high logical level "H", while the output signal "g", as shown in Figure 3G, at the output of NAND gate 44 remains at a low logical level "L". As a result, a signal appearing at the output terminal $A_6$ is not an alarm signal. Thus, each of two states depending upon the time-period of a signal compared with a reference signal correspond to either of two states of the latch circuit. Therefore, a state that the time-period of the signal is longer than that of the reference signal, i.e., that the rotational velocity of the fan is smaller than the rated value can be detected to produce an alarm signal by using one output of the latch circuit.

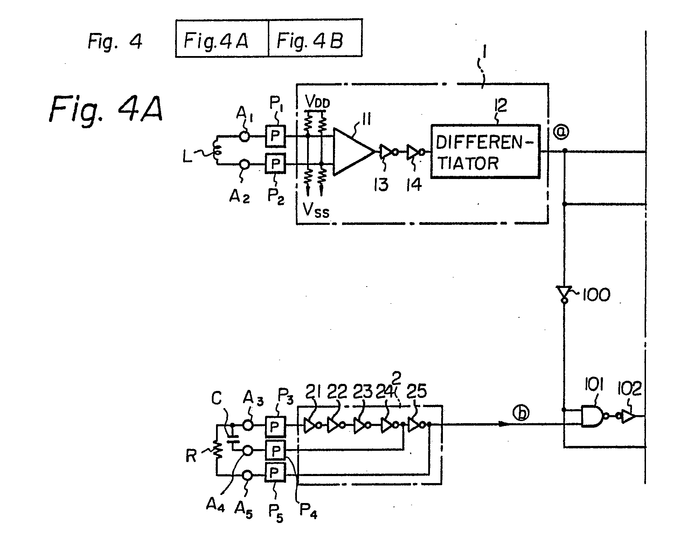

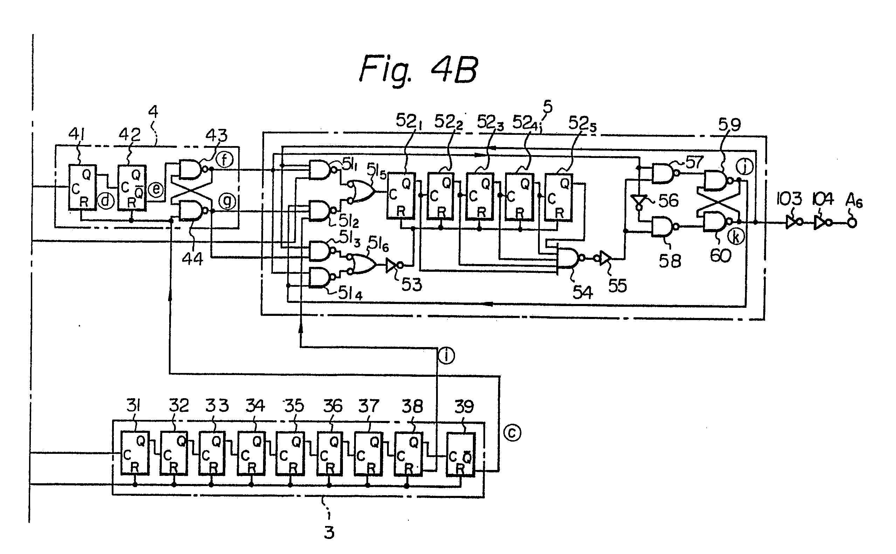

Figure 4 is a block circuit diagram illustrating a first embodiment of the period comparing device of the present invention. The elements illustrated in Figure 4 which are identical with those of Figure 1 are given the same reference numerals as used in Figure 1. The device of Figure 4 further includes a preventing circuit 5 for preventing this device from operating due to an irregular signal generated from a pickup (not shown) for detecting the rotational velocity of a fan (not shown). The inductance coil L installed in the pickup is used for detecting the rotational velocity of the fan. However, the inductance coil L may be excited by a strong electromagnetic field generated in the proximity of a motor for driving the fan. Such excited inductance coil L generates an irregular signal which causes the latch circuit of the signal circuit 4 to change its state often. The preventing circuit 5 is used for eliminating such an irregular signal. The preventing circuit 5 includes a latch circuit formed by two NAND gates 59 and 60 cross-coupled, which is similar to the latch circuit formed by two NAND gates 43 and 44. The preventing circuit 5 further includes a first group of gates, composed of two NAND gates $51_1$ and $51_2$, and one inverted input OR gate $51_5$. In this case, NAND gate $51_1$ transmits the signal "a" only when the output levels of both NAND gates 43 and 60 are at a high logical level "H", while NAND gate $51_2$ transmits the rectangular-wave part of the signal "i" at the output of the counter stage 38 only when the output levels of both NAND gates 44 and 59 are at a high logical level "H". Namely, either of NAND gates $51_1$ and $51_2$ transmits the signal "a" or the rectangular-wave part of the signal "i" when the states of the two latch circuits are different. The preventing circuit also includes a second group of gates composed of two NAND gates $51_3$ and $51_4$, and one inverted input OR gate $51_6$. In this case, one of the NAND gates $51_3$ and $51_4$ changes its output level when the output levels of the latch circuit formed by two NAND gates 43 and 44 changes, and the change is transmitted to the reset terminal of the n-ary counter (n equals $2^5$ in this case) composed of five binary counter stages $52_1$, $52_2$, $52_3$, $52_4$ and $52_5$. Thus, when the value of the n-ary counter is (n-1), the output level of NAND gate 54 becomes a low logical level "L". As a result, the state of the latch circuit formed by two NAND gates 43 and 44 is transmitted to the latch circuit formed by two NAND gates 59 and 60 through two NAND gates 57 and 58.

The operation of the device of Figure 4 will now be explained in detail.

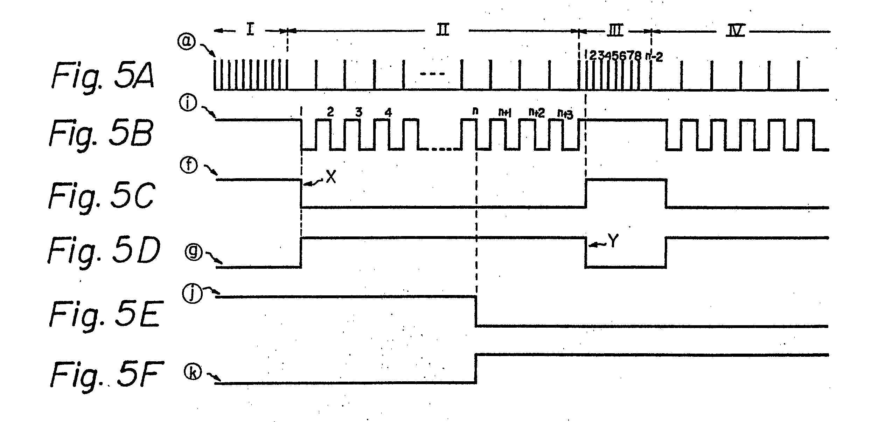

Figures 5A, 5B, 5C, 5D, 5E and 5F are timing diagrams showing the signals "a", "i", "f", "g", "j" and "k", respectively, appearing in Figure 4. For a first interval I, if it is assumed that the rotational velocity of the fan is higher than a predetermined value, the signal "a" at the output of the input circuit 1 is as shown in Figure 5A and a signal "i" generated from the counter stage 38 of the reference period counter 3 is at a high logical level "H". For this interval I, as has been mentioned in connection with Figure 1, the signal "f" at the output of NAND gate 43 is at a high logical level "H", as shown in Figure 5C, while the signal "g" at the output of NAND gate 44 is at a low logical level "L", as shown in Figure 5D.

For a second interval II, if it is assumed that the rotational velocity of the fan is lower than the predetermined value, the signal "a" is as shown in Figure 5A and the rectangular part of the signal "i" has a width of a rectangular wave which width is a half of that of the signal "c" at the output of the counter stage 39. Since the signal "k" is still at a low logical level "L", each of NAND gates $51_1$ and $51_3$ is in a closed state, so that each output of NAND gates $51_1$ and $51_3$ remains at a high logical level "H". On the other hand, NAND gates $51_2$ and $51_4$ are in an open state. Therefore, after the reset state of each of the binary counter stages $52_1$, $52_2$, $52_3$, $52_4$ and $52_5$ is released by the rear edge X of the signal "f" through NAND gate $51_4$, the inverted input OR gate $51_6$ and the inverter 53, the n-ary counter composed of the five counter stages (n equals $2^5$) begins to count the rear edges of the rectangular-wave part of the signal "i", as shown in Figure 5B. When the (n-1) rear edges of the rectangular-wave part of the signal "i" are counted by the n-ary counter composed of the counter stages $52_1$, $52_2$, $52_3$, $52_4$ and $52_5$, all the counter stages are set so that the output of NAND gate 54 becomes a low logical level "L", which is inverted to a high logical level "H" by the inverter 55. Therefore, the low logical level "L" at the output of NAND gate 43 is transmitted to an input of NAND gate 59, while a high logical level "H", inverted by the inverter 56, is transmitted to an input of NAND gate 60. As a result, the latch circuit formed by the two NAND gates 59 and 60 inverts its state, as shown in Figure 5E and Figure 5F.

For a third interval III, if it is assumed again that the rotational velocity of the fan is higher than the predetermined value, since the signal "j" is still at a low logical level "L", each of NAND gates $51_2$ and $51_4$ is in a closed state, so that each output of NAND gates $51_2$ and $51_4$ remains at a high logical level "H". On the other hand, NAND gates $51_1$ and $51_3$ are in an open state. Therefore, after the reset state of each of the binary counter stages $52_1$, $52_2$, $52_3$, $52_4$, and $52_5$ is released by the rear edge Y of the signal "g" through NAND gate $51_3$, the inverted input OR gate $51_6$ and the inverter 53, the n-ary counter begins to count pulses of the signal "a", as shown in Figure 5A. However, before the n-ary counter counts (n-1) pulses (n equals 32, here), the interval III is completed, so that the output of NAND gate 54 remains at a high logical level "H". As a result, the latch circuit formed by two NAND gates 59 and 60 does not invert its state as shown in Figures 5E and 5F.

As mentioned above, in response to the changes of the frequency of the input signal "a", the first latch circuit formed by two NAND gates 43 and 44 inverts its state. However, the second latch circuit formed by two NAND gates 59 and 60 does not always invert its state, after the first latch circuit inverts its state. Namely, the second latch circuit inverts its state only when the first latch circuit remains in a stable state continuously for more than a definite term which is determined by counting the pulses of the signal "a" or the rear edges of the rectangular-wave part of the signal "i". Therefore, even if the inductance coil L produces an irregular signal so that the first latch circuit often inverts its state, the second latch circuit will not invert its state. As a result, a signal at the out-put terminal $A_6$, which is connected to an output of the second latch circuit, serves as a reliable alarm signal.

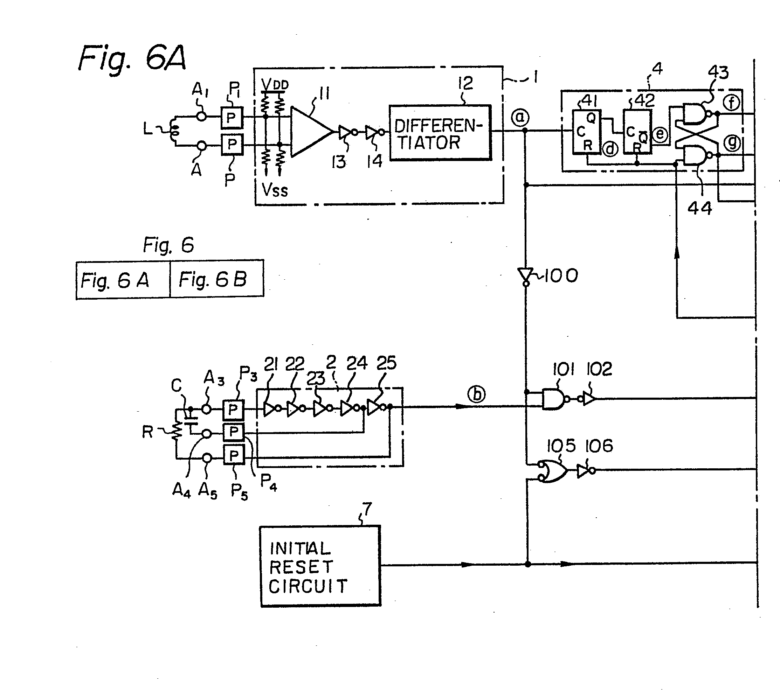

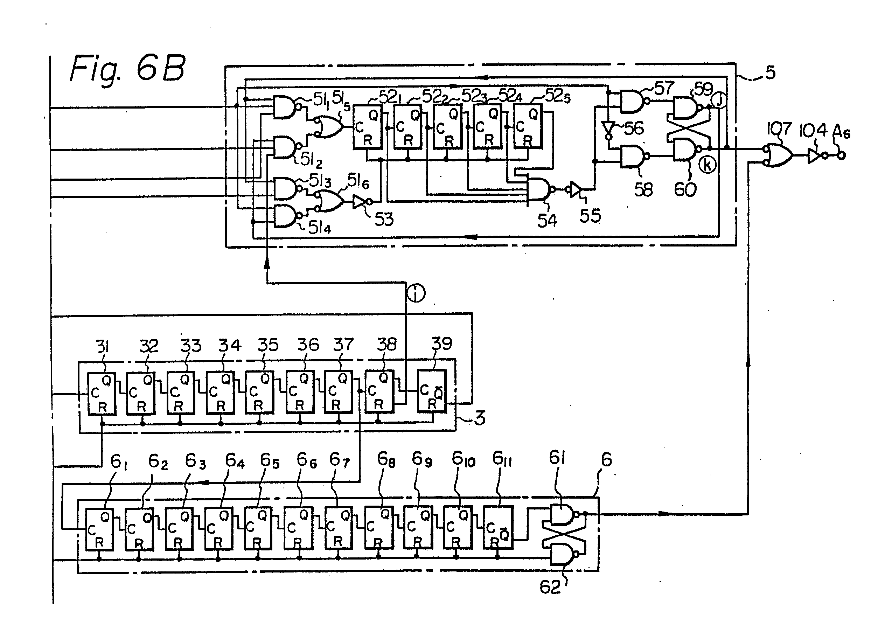

Figure 6 is a block circuit diagram illustrating a second embodiment of the time-period comparing device of the present invention. The elements illustrated in Figure 6 which are identical with those of Figure 4 are given the same reference numerals as in Figure 4. The device of Figure 6 further includes a stopping circuit 6 for preventing this device from producing an alarm signal for a definite interval after the power is turned on. Furthermore, the device includes an initial reset circuit 7 for resetting the counter stages contained in the reference period counter 3 and the stopping circuit 6 after the power is turned on. An inverted-input OR gate 105 receives both the pulse from the initial reset circuit and the inverted pulses $\alpha$, and is followed by an inverter 106. Namely, after the power is turned on, the initial reset circuit 7 produces only one reset pulse which is used for resetting the counter stages contained in the reference period counter 3 and the stopping circuit 6. After that, the initial reset circuit 7 produces a logical high level "H", which is maintained until the power is turned off.

The stopping circuit 6 is composed of an mary counter, composed of 11 binary counter stages $6_1$, $6_2$, ..., $6_{11}$ (m equals $2^n$) and a latch circuit formed by two NAND gates 61 and 62. When the last binary counter stage $6_{11}$ receives a reset pulse generated from the initial reset circuit 7, the output $\overline{Q}$ of the binary counter stage becomes a high logical level "H", which is applied to an input of NAND gate 61. On the other hand, a low logical level "L" is applied to an input of NAND gate 62. Therefore, the output of NAND 61 becomes a low logical level "L", which is applied to an input of the inverted input OR gate 107, so that the inverted input OR gate 107 is placed in a closed state, while the output of NAND gate 62 becomes a high logical level "H". Thus, even if the preventing circuit 5 produces an alarm signal from the output of NAND gate 60, the alarm signal can not be output from this device.

The reset pulse resets all the binary counter stages 31, 32, ..., 39; $6_1$, $6_2$, ..., $6_{11}$ so that the stages begin to count the pulses generated from the reference oscillator 2, whose frequency is, for example, 7.25 KHz. As a result, a signal whose time-period is about 18 sec ($2^{17}/7250$) is obtained at the output $\overline{Q}$ of the binary counter stage $6_{11}$. Namely, the output $\overline{Q}$ of the binary counter stage $6_{11}$ repeats a high logical level "H" of about 18 sec and a low logical level "L" of about 18 sec, alternately. However, since the output of the initial reset circuit 7 is maintained at a high logical level "H" until the power is off, the latch circuit formed by two NAND gates 61 and 62 inverts its state only in response to the first change of the output $\overline{Q}$ of the last counter stage $6_{11}$. After that, the output of NAND gate 61 is maintained at a high logical level "H", so that the inverted input OR gate 107 is maintained in a open state. Thus, the inverted input OR gate 107 is in a closed state for about 18 sec, for example, from the time the power is turned on. Namely, this device of Figure 6 never produces an alarm signal from its output terminal $A_6$ for about 18 sec from the time the power is turned on.

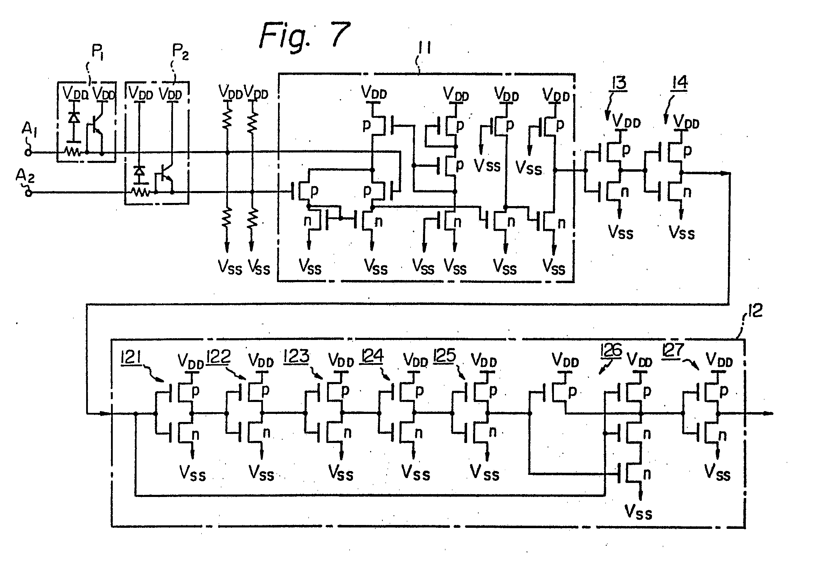

Figure 7 is a circuit diagram illustrating the input circuit 1 of the devices of Figures 1, 4 and 6. In Figure 7, the elements, such as a diode, a resistor and a transistor, in the protection circuit $P_1$ and $P_2$ may be manufactured by using Complementary Metal Oxide Semiconductor (hereinafter referred to as CMOS) technology. The differential amplifier 11 formed by twelve MOS transistors may also be manufactured by using CMOS technology. Usually, one CMOS inverter is composed of a p-type MOS transistor and a n-type MOS transistor. Each of the inverters 13 and 14 formed by two MOS transistors may be manufactured by using CMOS technology. The differentiator 12 is composed of a series of five inverters 121, 122, 123, 124 and 125, each of which is formed by two MOS transistors, a NAND gate 126, which is formed by four MOS transistors, and an inverter 127 formed by two MOS transistors, so that the differentiator 12 may be manufactured by using CMOS technology. In the differentiator 12, an input of the first inverter 121 and an output of the fifth inverter 125 are connected to inputs of NAND gate 126, respectively. Thus, the input circuit 1 as a whole may be manufactured by using CMOS technology.

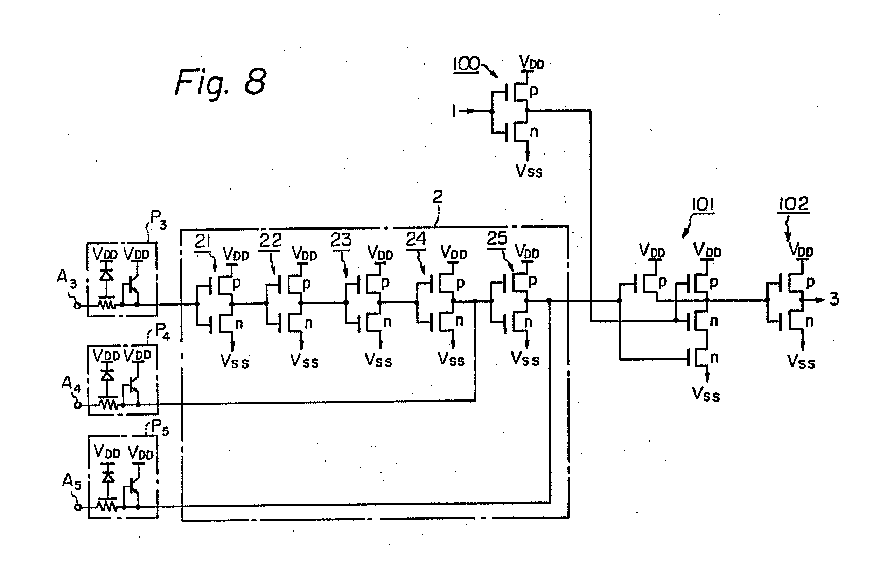

Figure 8 is a circuit diagram illustrating the reference oscillator 2 of the devices of Figures 1, 4 and 6. Each of the inverters 21, 22, 23, 24 and 25 is formed by two MOS transistors, so that the reference oscillator 2 as a whole may be manufactured by CMOS technology.

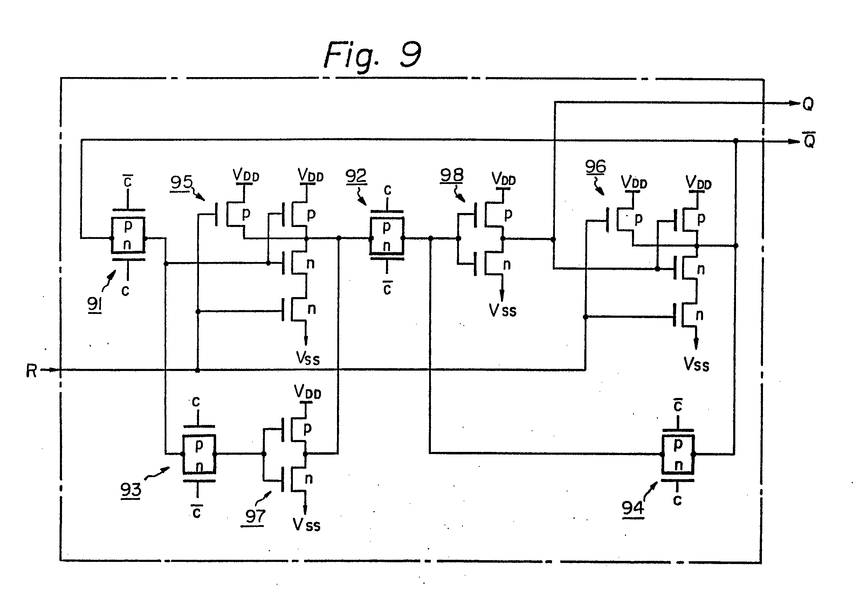

Figure 9 is a circuit diagram illustrating the binary counter stages of the devices of Figures 1, 4 and 6. In Figure 9, the binary counter is composed of: four transmission gates 91, 92, 93 and 94, each of which is formed by two MOS transistors; two NAND gates 95 and 96, each of which is formed by four MOS transistors, and; two inverters 97 and 98, each of which is formed by two MOS transistors. Therefore, the binary counter stages as a whole may be manufactured by using CMOS technology.

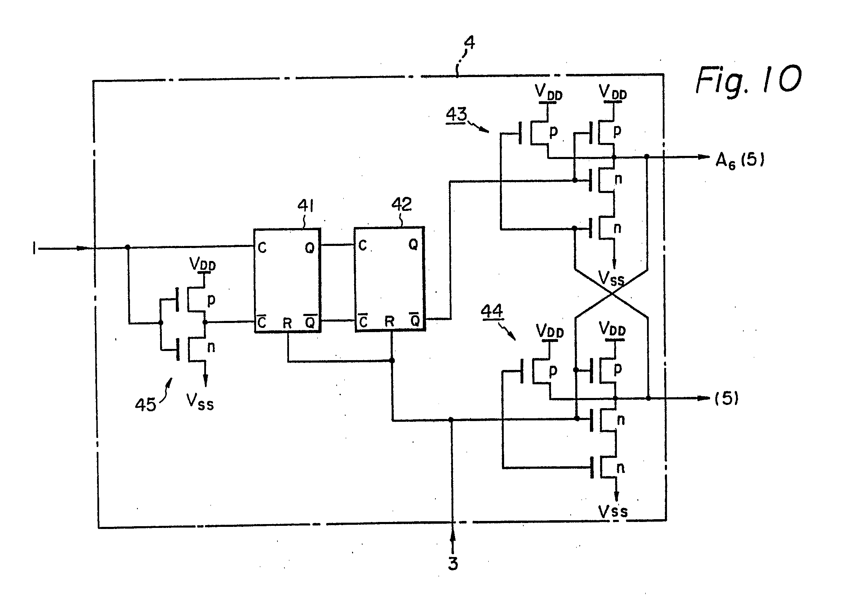

Figure 10 is a circuit diagram illustrating the signal circuit 4 of the devices of Figures 1, 4 and 6. As shown in Figure 10, each of the binary counter stages 41 and 42 has an inverting clock $\overline{C}$, which is omitted in Figures 1, 4 and 6, so that an inverter 45 formed by two MOS transistors is added in Figure 10. The elements, such as the binary counter stages 41 and 42, and NAND gates 43 and 44, are also formed by MOS transistors, so that the signal circuit 4 as a whole may be manufactured by using CMOS technology.

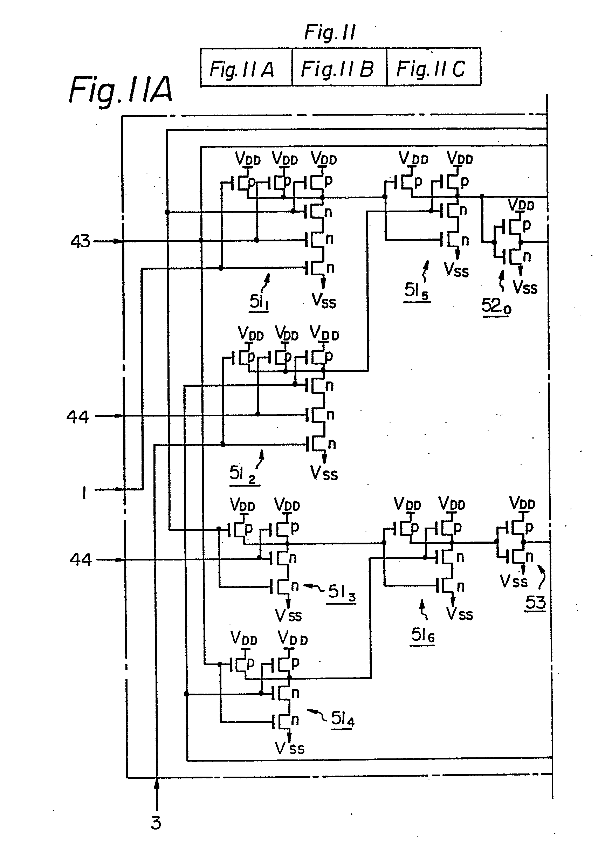

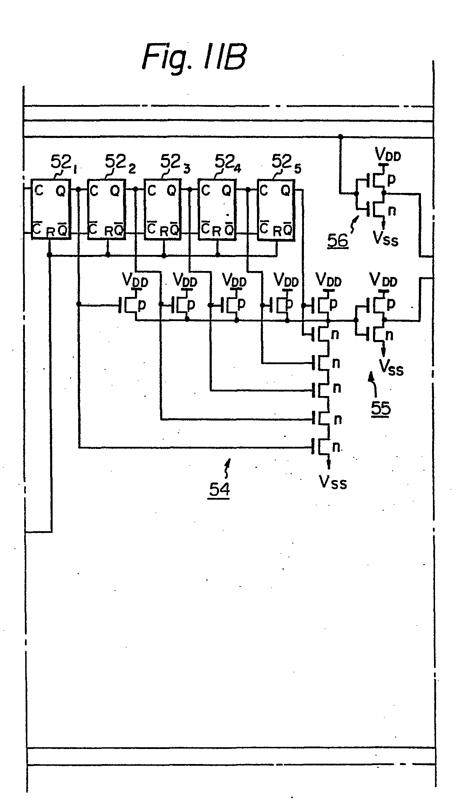

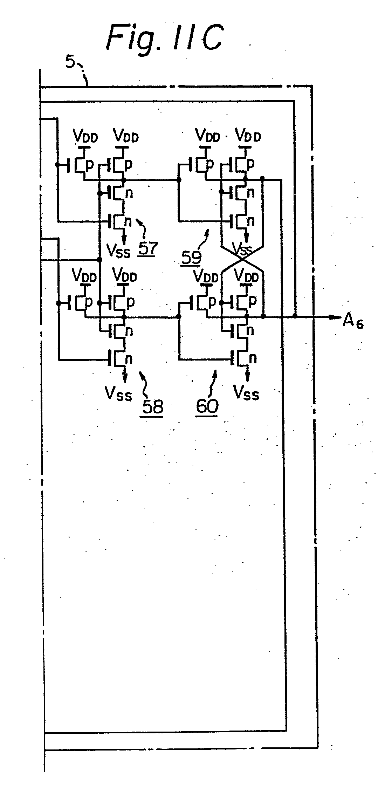

Figure 11 is a circuit diagram illustrating the preventing circuit 5 of the devices of Figures 4 and 6. In Figure 11, each of NAND gates $51_1$ and $51_2$ which have three inputs, is formed by six MOS transistors, and each of NAND gates $51_3$, $51_4$ and the inverted input OR gates $51_5$ and $51_6$ is formed by four MOS transistors. The output of the inverted input OR gate $51_6$ is connected to the reset terminals R of the binary counter stages $52_1$, $52_2$, $52_3$, $52_4$ and $52_5$ via the inverter 53, formed by two MOS transistors. Also, each of the binary counter stages has inverting on clock $\overline{C}$, which is omitted in Figures 4 and 6, so that an inverter $52_0$ formed by two MOS transistors is added in Figure 11. NAND gate 54, which has five inputs connected to outputs of the binary counter stages $52_1$, $52_2$, $52_3$, $52_4$ and $52_5$, respectively, is formed by ten MOS transistors. Furthermore, each of the inverters 55 and 56 is formed by two MOS transistors and each of NAND gates 57, 58, 59 and 60 is formed by four MOS transistors. As a result, the preventing circuit 5 as a whole may be manufactured by using CMOS technology.

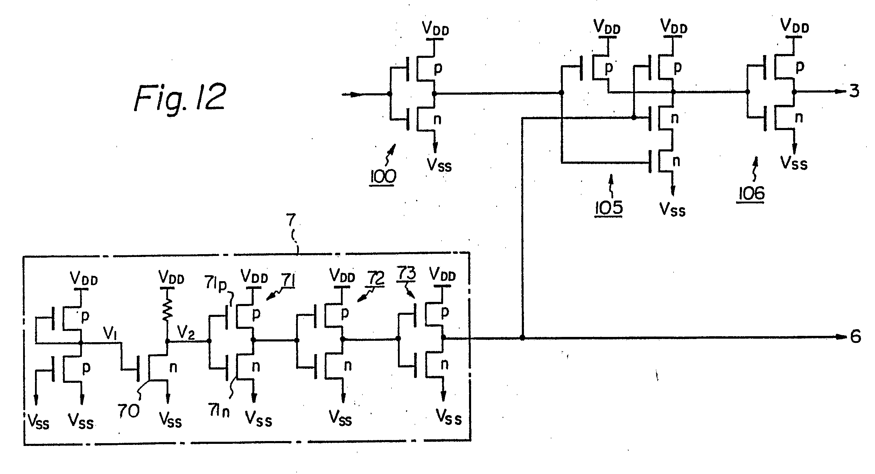

Figure 12 is a circuit diagram illustrating the initial reset circuit 7 of the device of Figure 6. In Figure 12, when the power is turned on, the voltage $V_{DD}$ goes up gradually so that the voltage $V_2$ goes up gradually. Then, at first, the n-type transistor $71_n$ in series with the transistor $71_p$ remains in a non-conducting state. When the voltage level $V_2$ ($V_{DD}$) becomes at a threshold value of the transistor $71_n$, the output level of the inverter 71 becomes at a low logical level "L". After that, when the voltage level $V_1$ becomes at a threshold value of the transistor 70, the transistor 70 conducts. As a result, the voltage level $V_2$ becomes a low level which is about the same as the voltage $V_{SS}$ so that the inverter 71 inverts its state to a high logical level "H". Thus, the initial reset circuit 7 provides through inverters 72 and 73 a pulse which is used for resetting the binary counter stages contained in the reference period counter 3 and the stopping circuit 6 and, after that, produces a high logical level "H" which is maintained until the power is turned off.

As has been mentioned above, each of the circuits contained in the devices of Figures 1, 4 and 6 may be manufactured by using CMOS technology. Therefore, each of the devices of Figures 1, 4 and 6 may be manufactured as an integrated circuit of an 8-terminal module by using CMOS technology. However, it should be noted that each of the devices of Figures 1, 4 and 6 can be manufactured by using only p-type MOS technology or only n-type MOS technology, instead of CMOS technology.

The period comparing device described above has the following advantageous features:

(1) The time-period comparing device is of a relatively small size and is low in cost, because it can be manufactured as a small integrated circuit with a small number of terminals by using CMOS technology, p-type MOS technology or n-type MOS technology. Therefore, this device is easy to mount on fan systems.

(2) The time-period comparing device can operate properly, regardless of ambient conditions, because a circuit for generating a reference period signal includes no high value capacitors which are sensitive to ambient conditions, such as ambient temperature.

(3) The time-period comparing device can operate properly, even if an irregular signal is input to the device, because this device includes means for preventing it from operation by such an irregular signal.

(4) The time-period comparing device can operate properly just after the power is turned on, because this device includes means for stopping the generation of an alarm signal for a definite interval from the time the power is turned on.

## Claims

1. A period comparing device for comparing the period (T) of a first signal (a) with a second period (reference period t) defined by a predetermined multiple of a shorter period $(t_o)$ of a second signal (b), the second period (t) being obtained by means of a counter (3) receiving the second signal (b) and reaching a count equal to the predetermined multiple if not previously interrupted by the said first signal (a) and generating either a rectangular signal (Figure 2C) defining the reference period (t) or a definite level signal (Figure 3C), the type of signal generated depending on the period (T) of the first signal (a) being longer ($T_1$) or shorter ($T_2$) than the reference period (t), and comprising a signal circuit (4) producing two different definite-level signals (Figure 2F, Figure 3F) depending on the period (T) of the first signal (a) being longer ($T_1$) or shorter ($T_2$) than the said reference period (t), characterized

(a) in that the first signal (a) is an input signal to be monitored,

(b) an oscillator (2) provides the signal (b) of shorter period $(t_o)$ and

(c) by means (5) for preventing the device from operating when the input signal (a) is an irregular signal, the preventing means having two output states (j, k), the preventing means in the first output state counting the number of pulses derived from the input signal (a), following a change in the signal circuit output, and being reset by a subsequent output signal (g) provided by the signal circuit (4) if that signal (g) arrives before the number of pulses has reached a predetermined value, the preventing means in the second output state counting the number of pulses derived from an output signal (i) of the counter (3), following a change in the signal circuit output, and being reset by another subsequent output signal (f) provided by the signal circuit (4) if that signal (f) arrives before the number of pulses has reached the predetermined value, the preventing means changing from one output state to the other following the corresponding change in the output of the signal circuit, only when the number of pulses derived from the input signal (a) or from the output signal (i) of the counter (3) reaches the predetermined value.

2. A device according to claim 1, characterized in that the counting of pulses by the preventing means (5) is initiated when the output signal (f, g) provided by the signal circuit (4) changes from one level to the other.

3. A device according to claim 2, characterized in that the preventing means (5) includes a counter (52); and by an output latch circuit (59, 60); by first gating means ($51_1$, $51_2$) responsive to the state of the signal (f, g) produced by the signal circuit (4) and the state (k, j) of the output latch circuit (59, 60), the first gating means ($51_1$, $51_2$) being operative when the two states are different to apply to the counter (52) a pulsed signal derived from the input signal (a) or the reference signal (i); by second gating means ($51_3$, $51_4$) responsive to the signal (g, f) produced by the signal circuit (4) to reset the counter (52) if the signal from the signal circuit (4) changes; and by third gating means (57, 58) connected to the output of the counter (52) and operative to transmit the signal (f, g) derived from the signal circuit (4) to the output latch circuit (59, 60) when the count in the counter (52) reaches a predetermined value, to ensure that the output latch circuit (59, 60) assumes the state represented by the signal (f, g) from the signal circuit (4).

4. A device according to claim 1, characterized in that the signal circuit (4) includes a second counter (41, 42) receiving the input signal (a) as a clock signal and receiving the output signal from first-mentioned counter (3) as a reset signal, an output signal (e) of the counter (41, 42) being either a logical level signal or a rectangular wave signal, in dependence on the period of the input signal, the signal circuit (4) further including a latch circuit (43, 44), two inputs of which are connected to an output of the second counter (41, 42) and to the output of the first-mentioned counter (3), respectively, whereby the latch circuit (43, 44) assumes one of the said two definite-level states (f, g) in dependence on the period (T) of the input signal (a) relative to the reference period (t).

5. A device in accordance with claim 1 or 2, characterized by delay means (6) for preventing the device from operating for a definite interval after the power is turned on, including a third counter ($6_1$—$6_{11}$) counting pulses generated by the oscillator (2), the delay means (6) further including a latch circuit (61, 62), two inputs of which are connected to an output and a reset terminal of the said counter (6); and initial reset means (7) for resetting the said counter (6) when the power is turned on.

6. A device in accordance with claim 5, characterized by an inverted input OR gate (107), producing an output signal from the said device which is connected to outputs of the latch circuit (59, 60) of the said preventing means (5) and the latch circuit (61, 62) of the delay means (6) whereby the inverted input OR gate (107) is in a closed state for the said definite interval.

7. A device as set forth in any one of the preceding claims, characterized in that the oscillator (2) includes a plurality of inverters (21—25) connected in series, an output of an even-numbered one (24) of the said inverters being connected to the first inverter (21) via an external capacitor (C), and an output of an odd-numbered one (25) of the inverters being connected to the first inverter (21) via an external resistor (R), whereby the values of the external capacitor (C) and the external resistor (R) determine the oscillating frequency of the oscillator (2).

**Patentansprüche**

1. Perioden-Vergleichsvorrichtung zum Vergleich der Periode (T) eines ersten Signals (a) mit einer zweiten Periode (Referenzperiode t), welche durch ein vorbestimmtes Vielfaches einer kürzeren Periode ($t_0$) eines zweiten Signals (b) definiert ist, wobei die zweiten Periode (t) mittels eines Zählers (3) erhalten wird, der das zweite Signal (b) empfängt und einen Zählstand erreicht, welcher gleich dem vorbestimmten Vielfachen ist, falls er nicht vorher durch das genannte erste Signal (a) unterbrochen wird, und entweder ein Rechtecksignal (Fig. 2C) erzeugt, welches die Referenzperiode (t) bestimmt, oder ein Signal (Fig. 3C) mit definiertem Pegel, wobei die Art des erzeugten Signals davon abhängt, ob die Periode (T) des ersten Signals (a) länger ($T_1$) oder kürzer ($T_2$) als die Referenzperiode (t) ist, und mit einer Signalschaltung (4), welche zwei verschiedene Signale, definierten Pegels (Fig. 2F, Fig. 3F) erzeugt, abhängig davon, ob die Periode (T) des ersten Signals (a) länger ($T_1$) oder kürzer ($T_2$) als die genannte Referenzperiode ist, dadurch gekennzeichnet,

(a) daß das erste Signal (a) ein zu überwachendes Eingangssignal ist,

(b) ein Oszillator (2) das Signal (b) mit der kürzeren Periode ($t_0$) liefert, und

(c) durch ein Verhinderungseinrichtung (5) zur Verhinderung des Betriebs der Vorrichtung, wenn das Eingangssignal (a) ein unregelmäßiges Signal ist, die zwei Ausgangszustände (j, k) hat, und die in dem ersten Ausgangszustand die Anzahl der von dem Eingangssignal (a) abgeleiteten Impulse zählt, die einem Wechsel des Ausgangssignals der Signalschaltung folgen, und durch ein folgendes Ausgangssignal (g) zurückgesetzt wird, welches von der Signalschaltung (4) geliefert wird, falls das Signal (g) ankommt, bevor die Anzahl der Impulse einen vorbestimmten Wert erreicht hat, und die in dem zweiten Ausgangszustand die Impulse zählt, welche von einem Ausgangssignal (i) des Zählers (3) abgeleitet werden, welche nach einem Wechsel des Ausgangssignals der Signalschaltung folgen, und von einem anderen folgenden Ausgangssignal (f) zurückgesetzt wird, welches von der Signalschaltung (4) geliefert wird, falls das Signal (f) ankommt, bevor die Anzahl der Impulse den vorbestimmten Wert erreicht hat, wobei die Verhinderungseinrichtung von einem Ausgangszustand zu dem anderen dem entsprechenden Wechsel des Ausgangs der Signalschaltung folgend, nur dann wechselt, wenn die Anzahl der Impulse, die von dem Eingangssignal (a) oder von dem Ausgangssignal (i) des Zählers (3) abgeleitet werden, einen vorbestimmten Wert erreicht.

2. Vorrichtung nach Anspruch 1, dadurch gekennzeichnet, daß die Zählung der Impulse durch die Verhinderungseinrichtung (5) initiiert wird, wenn das Ausgangssignal (f, g), das von der Signalschaltung (4) geliefert wird, von einem Pegel zu dem anderen wechselt.

3. Vorrichtung nach Anspruch 2, dadurch gekennzeichnet, daß die Verhinderungseinrichtung (5) einen Zähler (52) umfaßt, und durch eine Ausgangshalteschaltung (59, 60), durch eine erste Gatterschaltung (51₁, 51₂), die auf den Zustand des Signals (f, g), das durch die Signalschaltung (4) erzeugt wird, und den Zustand (k, j) der Ausgagshalteschaltung (59, 60) anspricht, wobei die erste Gatterschaltung (51₁, 51₂) tätig wird, wenn die beiden Zustände verschieden sind, um dem Zähler (52) ein gepulstes Signal zuzuführen, welches von dem Eingangsignal (a) oder dem Referenzsignal (i) abgeleitet ist, durch eine zweite Gatterschaltung (51₃, 51₄), die auf das Signal (g, f) anspricht, das von der Signalschaltung (4) erzeugt wird, um den Zähler (52) zurückzusetzen, falls das Signal von der Signalschaltung (4) wechselt, und durch eine dritte Gatterschaltung (57, 58), die mit dem Ausgang des Zählers (52) verbunden ist und tätig wird, um das von der Signalschaltung (4) abgeleitete Signal (f, g) zu der Ausgangschalteschaltung (59, 60) zu übertragen, wenn der Zählstand in dem Zähler (52) einen vorbestimmten Wert erreicht, um sicherzustellen, daß die Ausgangschalteschaltung (59, 60) den Zustand annimmt, der durch das Signal (f, g) von der Signalschaltung (4) dargestellt wird.

4. Vorrichtung nach Anspruch 1, dadurch gekennzeichnet, daß die Signalschaltung (4) einen zweiten Zähler (41, 42) umfaßt, der das Eingangssignal (a) als Taktsignal und das Ausgangssignal von dem erstgenannten Zähler (3) als ein Rückstellsignal empfängt, ein Ausgangssignal (e) des Zählers (41, 42) entweder ein Logikpegelsignal oder ein rechteckiges Wellensignal ist, abhängig von der Periode des Eingangssignals, die Signalschaltung (4) ferner eine Halteschaltung (43, 44) umfaßt, deren zwei Eingänge mit einem Ausgang des zweiten Zählers (41, 42) bzw. mit dem Ausgang des erstgenannten Zählers (3) verbunden sind, wodurch die Halteschaltung (43, 44), in Abhängigkeit von der Periode (T) des Eingangssignal (a) relativ zu der Referenzperiode (t), einen der beiden Zustände vorbestimmten Pegels (f, g) annimt.

5. Vorrichtung nach Anspruch 1 oder 2, gekennzeichnet durch eine Verzögerungseinrichtung (6) zur Verhinderung des Betriebs der Vorrichtung während eines definierten Intervalls nach Einschalten des Stroms, mit einem dritten Zähler (6₁—6₁₁), welcher die Impulse zählt, die von dem Oszillator (2) erzeugt werden, wobei die Verzögerungseinrichtung (6) ferner eine Halteschaltung (61, 62) umfaßt, deren zwei Eingänge mit einem Ausgang bzw. einem Rückstelleingang des genannten Zählers (6) verbunden sind, und durch eine Anfangs-Rückstelleinrichtung (7) zur Rückstellung des genannten Zählers (6), wenn der Strom eingeschaltet wird.

6. Einrichtung nach Anspruch 5, gekennzeichnet durch ein ODER-Glied (107) mit invertierten Eingängen, welches ein Ausgangssignal von der genannten Vorrichtung erzeugt und mit den Ausgängen der Halteschaltung (59, 60) der genannten Verhinderungseinrichtung (5) und der Halteschaltung (61, 62) der Verzögerungseinrichtung (6) verbunden ist, wodurch das ODER-Glied (107) mit invertierten Eingängen während des genannten definierten Intervalls in gesperrtem Zustand ist.

7. Vorrichtung nach einem der vorhergehenden Ansprüche, dadurch gekennzeichnet, daß der Oszillator (2) eine Anzahl von Invertern (21—25) umfaßt, die in Reihe geschaltet sind, ein Ausgang ein gradzahliger Inverter (24) mit dem ersten Inverter (21) über einen äußeren Kondensator (C) verbunden ist, und ein Ausgang eines ungeradzahligen Inverters (25) mit dem ersten Inverter (21) über einen äußeren Widerstand (R) verbunden ist, wodurch die Werte des äußeren Kondensators (C) und des äußeren Widerstands (R) die Schwingungsfrequenz des Oszillators bestimmen.

## Revendications

1. Un dispositif de comparaison de période destiné à comparer la période (T) d'un premier signal (a) avec une seconde période (période de référence t) définie par un multiple prédéterminé d'une période plus courte ($t_n$) d'un second signal (b), la seconde période (t) étant obtenue au moyen d'un compteur (3) qui reçoit le second signal (b) et atteint un compte égal au multiple prédéterminé s'il n'a pas été interrompu précédemment par le premier signal (a), et à générer soit un signal rectangulaire (figure 2C) définissant la période de référence (t), soit un signal de niveau défini (figure 3C), le type du signal généré dépendant du fait que la période (T) du premier signal (a) est plus longue ($T_1$) ou plus courte ($T_2$) que la période de référence (t), et comprenant un circuit générateur de signal (4) destiné à produire deux signaux différents de niveau défini (figure 2F, figure 3F) selon que la période (T) du premier signal (a) est plus longue ($T_1$) ou plus courte ($T_2$) que la période de référence (t), caractérisé

(a) en ce que le premier signal (a) est un signal d'entrée à surveiller,

(b) un oscillateur (2) produit le signal (b) ayant une période plus courte ($t_o$) et

(c) il existe des moyens (5) destinés à interdire le fonctionnement du dispositif lorsque le signal d'entrée (a) est un signal irrégulier; les moyens d'interdiction comportent deux états de sortie (j, k); dans le premier état, les moyens d'interdiction comptent le nombre d'impulsions obtenues à partir du signal d'entrée (a), à la suite d'un changement de la sortie du circuit générateur de signal, et ils sont restaurés par un signal de sortie suivant (g) produit par le circuit générateur de signal (4) si ce signal (g) arrive avant que le nombre d'impulsions ait atteint une valeur prédéterminée; dans le second état, les moyens d'interdiction comptent le nombre d'impulsions obtenues à partir d'un signal de sortie (i) du compteur (3), à la suite d'un changement de la sortie du circuit générateur de signal, et ils sont restaurés par un autre signal de sortie suivant (f) produit par le circuit générateur de signal (4), si ce signal (f) arrive avant que le nombre d'impulsions ait atteint la valeur prédéterminée; et les moyens d'interdiction ne passent d'un état de sortie à l'autre, à la suite du changement correspondant de la sortie du circuit générateur de signal, que lorsque le nombre d'impulsions obtenues à partir du signal d'entrée (a) ou du signal de sortie (i) du compteur (3) atteint la valeur prédéterminée.

2. Un dispositif selon la revendication 1, caractérisé en ce que le comptage d'impulsions par les moyens d'interdiction (5) est commencé lorsque le signal de sortie (f, g) que fournit le circuit générateur de signal (4) passe d'un niveau à l'autre.

3. Un dispositif selon la revendication 2, caractérisé en ce que les moyens d'interdiction (5) comprennent un compteur (52); et par un circuit de bascule de sortie (59, 60); par un premier circuit de transmission sélective ($51_1$, $51_2$) qui réagit à l'état du signal (f, g) produit par le circuit générateur de signal (4) et à l'état (k, j) du circuit de bascule de sortie (59, 60), le premier circuit de transmission sélective ($51_1$, $51_2$) appliquant au compteur (52), lorsque les deux états sont différents, un signal sous forme d'impulsions qui est obtenu à partir du signal d'entrée (a) ou du signal de référence (i); par des seconds moyens de transmission sélective ($51_3$, $51_4$) qui réagissent au signal (g, f) produit par le circuit générateur de signal (4) en restaurant le compteur (52) si le signal provenant du circuit générateur de signal (4) change; et par des troisièmes moyens de transmission sélective (57, 58) connectés à la sortie du compteur (52) et transmettant au circuit de bascule de sortie (59, 60) le signal (f, g) qui est fourni par le circuit générateur de signal (4), lorsque le compte dans le compteur (52) atteint une valeur prédéterminée, pour faire en sorte que le circuit de bascule de sortie (59, 60) prenne l'état représenté par le signal (f, g) provenant du circuit générateur de signal (4).

4. Un dispositif selon la revendication 1, caractérisé en ce que le circuit générateur de signal (4) comprend un second compteur (41, 42) qui reçoit le signal d'entrée (a) en tant que signal d'horloge et qui reçoit le signal de sortie du compteur mentionné en premier (3) en tant que signal de restauration, un signal de sortie (3) du compteur (41, 42) étant soit un signal à niveau logique, soit un signal sous forme d'onde rectangulaire, en fonction de la période du signal d'entrée, le circuit générateur de signal (4) comprenant en outre un circuit de bascule (43, 44) dont deux entrées sont respectivement connectées à une sortie du second compteur (41, 42) et à la sortie du compteur (3) mentionné en premier, grâce à quoi le circuit de bascule (43, 44) prend l'un des deux états de niveau défini (f, g) en fonction de la valeur de la période (T) du signal d'entrée (a) par rapport à la période de référence (t).

5. Un dispositif selon la revendication 1 ou 2, caractérisé par des moyens de retard (6) destinés à empêcher le fonctionnement du dispositif pendant un intervalle défini après la mise sous tension, comprenant un troisième compteur ($6_1$—$6_{11}$) qui compte des impulsions produites par l'oscillateur (2), les moyens de retard (6) comprenant en outre un circuit de bascule (61, 62) dont deux entrées sont connectées à une sortie et à une borne de restauration du compteur (6); et des moyens de restauration initiale (7) destinés à restaurer le compteur (6) à la mise sous tension.

6. Un dispositif selon la revendication 5, caractérisé par une porte OU à entrées inversées (107), produisant un signal de sortie du dispositif, qui est connectée à des sorties du circuit de bascule (59, 60) des moyens d'interdiction (5), et au circuit de bascule (61, 62) des moyens de retard (6), grâce à quoi la porte OU à entrées inversées (107) est dans un état fermé pendant ledit intervalle défini.

7. Un dispositif selon l'une quelconque des revendications précédentes, caractérisé en ce que l'oscillateur (2) comprend un certain nombre d'inverseurs (21—25) connectés en série, une sortie de l'un (24) des inverseurs ayant un rang pair est connecté au premier inverseur (21) par l'intermédiaire d'un condensateur externe (C), et une sortie de l'un (25) des inverseurs ayant un rang impair est connectée au premier inverseur (21) par l'intermédiaire d'une résistance externe (R), grâce à quoi les valeurs du condensateur externe (C) et de la résistance externe (R) déterminent la fréquence d'oscillation de l'oscillateur (2).

Fig. 1

Fig. 2A

Fig. 2B

Fig. 2C

Fig. 2D

Fig. 2E

Fig. 2F

Fig. 2G

0 005 946

Fig. 3A

Fig. 3B

Fig. 3C

Fig. 3D

Fig. 3E

Fig. 3F

Fig. 3G

Fig. 4

| Fig. 4 A | Fig. 4 B |

Fig. 4A

Fig. 4B

Fig. 5A

Fig. 5B

Fig. 5C

Fig. 5D

Fig. 5E

Fig. 5F

# Fig. 6A

Fig. 6

| Fig. 6 A | Fig. 6 B |
|----------|----------|

*Fig. 6B*

Fig. 7

Fig. 8

Fig. 9

Fig. 10

Fig.II

| Fig.II A | Fig.II B | Fig.II C |

Fig.IIA

# Fig. IIB

# Fig. IIC

Fig. 12